# EUROPEAN PATENT APPLICATION

(11) **EP 4 554 337 A1**
(43) Date of publication of application: **14.05.2025**
(21) Application number: 24211712.5
(22) Date of filing: 08.11.2024
(51) Int. Cl.: H05K 1/02, B81C 1/00, H05K 1/18

(54) **SUBSTRATE COMPRISING A MOUNTED SEMICONDUCTOR**

(30) Priority: 10.11.2023 JP 2023192391
(71) Applicant: Niterra Co., Ltd., Nagoya-shi, Aichi 461-0005 (JP)
(72) Inventor: Hando, Takuya, Nagoya-shi, Aichi, 4610005 (JP); Shiraki, Fumio, Nagoya-shi, Aichi, 4610005 (JP); Jin, Guangzhu, Nagoya-shi, Aichi, 4610005 (JP); Hasegawa, Tatsuya, Nagoya-shi, Aichi, 4610005 (JP)
(74) Representative: Grünecker Patent- und Rechtsanwälte PartG mbB

(57) **Abstract**

Provided is a technology for enhancing adhesion between a base and a metal member in a semiconductor substrate. The semiconductor substrate includes: a base; a metal member containing a nonmagnetic material and having a nonmagnetic property; a conductive film formed on the metal member and made of the same material as the nonmagnetic material contained in the metal member; and a joining portion joining a side of the metal member where the conductive film is formed, to the base, the joining portion being made of a nonmagnetic material.

## Description

### TECHNICAL FIELD

The present invention relates to a semiconductor substrate.

### BACKGROUND ART

Conventionally, there has been known a semiconductor substrate in which a metal member is joined to a base (for example, Patent Documents 1 and 2).

### PRIOR ART DOCUMENT

### PATENT DOCUMENT

Patent Document 1: Japanese Patent No. 6629317
Patent Document 2: Japanese Patent No. 6883513

### SUMMARY OF THE INVENTION

### PROBLEM TO BE SOLVED BY THE INVENTION

However, even with conventional technologies as in Patent Documents 1 and 2, there is still room for improvement regarding technology for enhancing adhesion between the base and the metal member in the semiconductor substrate.

An object of the present invention is to provide a technology for enhancing adhesion between a base and a metal member in a semiconductor substrate.

### MEANS FOR SOLVING THE PROBLEM

The present invention has been made to solve at least one of the above problems and can be implemented as the following aspects.
(1) One aspect of the present invention provides a semiconductor substrate. This semiconductor substrate includes: a base; a metal member containing a nonmagnetic material and having a nonmagnetic property; a conductive film formed on the metal member and made of the same material as the nonmagnetic material contained in the metal member; and a joining portion joining a side of the metal member where the conductive film is formed, to the base, the joining portion being made of a nonmagnetic material.
   According to the above configuration, the conductive film formed on the metal member is made of the same material as the nonmagnetic material contained in the metal member. Thus, adhesion between the metal member and the conductive film is enhanced, whereby it is possible to enhance adhesion between the base and the metal member joined via the conductive film and the joining portion.
(2) In the semiconductor substrate of the above aspect, the base may include an insulating member made of a nonmagnetic material, and a nonmagnetic film formed on the insulating member. According to the above configuration, the base includes the insulating member made of a nonmagnetic material, and the nonmagnetic film formed on the insulating member, and therefore has a nonmagnetic property. Thus, the base having a nonmagnetic property and the metal member having a nonmagnetic property are joined via the joining portion made of a nonmagnetic material, whereby the semiconductor substrate has a nonmagnetic property. Accordingly, the entire semiconductor substrate is less influenced by a magnetic field and therefore can be applied to fields in which a nonmagnetic property is needed.
(3) The semiconductor substrate of the above aspect may further include a barrier film formed between the conductive film and the joining portion. According to the above configuration, the barrier film formed between the conductive film and the joining portion can inhibit the material contained in the joining portion from being dispersed into the conductive film.
(4) In the semiconductor substrate of the above aspect, the metal member may be made of an alloy of tungsten and copper, and the conductive film may be made of copper. According to the above configuration, the conductive film is formed of copper which is the nonmagnetic material forming the metal member. Thus, the conductive film becomes less likely to be separated from the metal member, so that adhesion between the metal member and the conductive film is enhanced. Accordingly, it is possible to enhance adhesion between the base and the metal member joined via the conductive film and the joining portion.

The present invention can be implemented in various aspects. For example, the present invention can be implemented in aspects such as a semiconductor package including a semiconductor substrate, a manufacturing method for a semiconductor substrate, a computer program for executing manufacturing of a semiconductor substrate, and the like.

### BRIEF DESCRIPTION OF THE DRAWINGS

[Fig. 1] Sectional view of a semiconductor substrate of a first embodiment.
[Fig. 2] First view illustrating a manufacturing method for the semiconductor substrate of the first embodiment.
[Fig. 3] Second view illustrating a manufacturing method for the semiconductor substrate of the first embodiment.
[Fig. 4] Third view illustrating a manufacturing method for the semiconductor substrate of the first embodiment.
[Fig. 5] Fourth view illustrating a manufacturing method for the semiconductor substrate of the first embodiment.

### MODES FOR CARRYING OUT THE INVENTION

### <First embodiment>

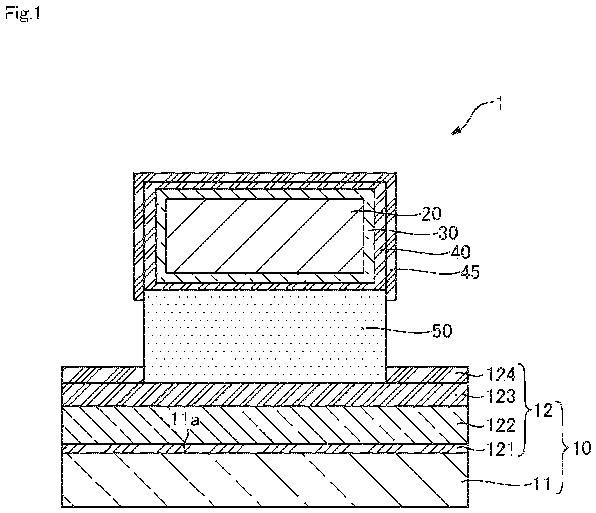

Fig. 1 is a sectional view of a semiconductor substrate of a first embodiment. A semiconductor substrate 1 of the present embodiment is a substrate to which a semiconductor is mounted, and includes a heat sink for releasing heat generated at the semiconductor to outside. The semiconductor substrate 1 of the present embodiment is mainly used in a case where a nonmagnetic property is needed in a superconductive environment, e.g., in a quantum computer. The semiconductor substrate 1 includes a base 10, a metal member 20, a conductive film 30, a barrier film 40, and a joining portion 50. In Fig. 1 to Fig. 5, the relationship of the thicknesses of the base 10, the metal member 20, the conductive film 30, the barrier film 40, and the joining portion 50 is shown differently from an actual thickness relationship, for convenience of description.

The base 10 includes an insulating member 11 made of a nonmagnetic material, and a nonmagnetic film 12 formed on the insulating member 11. The base 10 supports the metal member 20 described later and the semiconductor (not shown).

The insulating member 11 is a member having a flat-plate shape. The insulating member 11 is made of a nonmagnetic material having an insulation property, e.g., aluminum nitride (AlN), and has an insulating property. Here, "having an insulating property" means that an insulation resistance value is not less than 1.0×10⁸ Ω. The shape of the insulating member 11 is not limited thereto, and may be such a shape that can support the metal member 20 and the semiconductor. The nonmagnetic material forming the insulating member 11 is not limited to aluminum nitride. Oxide-based ceramic such as alumina (Al₂O₃), silica (SiO₂), titania (HO₂), or zirconia (ZrO₂), nitride-based ceramic such as silicon nitride (SiN) or titanium nitride (TiN), or the like may be used.

The nonmagnetic film 12 is formed on a surface 11a of the insulating member 11. The nonmagnetic film 12 includes a titanium film 121 made of titanium (Ti), a copper film 122 made of copper (Cu), a platinum film 123 made of platinum (Pt), and a gold film 124 made of gold (Au). In the nonmagnetic film 12 of the present embodiment, the titanium film 121, the copper film 122, the platinum film 123, and the gold film 124 are laminated in this order from the surface 11a side of the insulating member 11.

The base 10 includes the insulating member 11 made of a nonmagnetic material, and the nonmagnetic film 12 made of metal that is a nonmagnetic material, and thus the base 10 has a nonmagnetic property. Here, "having a nonmagnetic property" means having almost no magnetic property, and a small amount of magnetic material may be contained. In the present embodiment, a "member having a nonmagnetic property" is such a member that an average amount obtained by dividing the total amount of elements that exhibit a magnetic property, e.g., iron (Fe), nickel (Ni), cobalt (Co), and neodymium (Nd) contained in a plurality of measurement target areas set for the member, by the number of the measurement target areas, is not greater than a specific value. Specifically, using a scanning electron microscope (SEM) and an energy dispersive X-ray spectrometer (EDS), elemental analysis is performed for at least ten measurement target areas set on a surface or a cross-section of a member, under a predetermined measurement condition (magnification: 5000x, acceleration voltage of an electron gun: 20 kV, and a distance from the electron gun to the measurement target area: 10 mm). In the present embodiment, such a member that an average detection amount of elements that exhibit a magnetic property is not greater than 1.0 wt% as a result of the above elemental analysis is defined as a "member having a nonmagnetic property". The base 10 is a "member having a nonmagnetic property", in which an average detection amount of elements that exhibit a magnetic property is not greater than 1.0 wt%.

The metal member 20 is a member containing a nonmagnetic material and having a nonmagnetic property. In the present embodiment, the metal member 20 is a heat sink made of an alloy of tungsten (W) and copper. The metal member 20 has a function of releasing heat generated at the semiconductor mounted to the semiconductor substrate 1, to outside.

The conductive film 30 is formed on the metal member 20. The conductive film 30 is made of the same material as the nonmagnetic material contained in the metal member 20. In the present embodiment, the conductive film 30 is made of copper, of tungsten and copper contained in the metal member 20. As shown in Fig. 1, the conductive film 30 is formed so as to coat the entirety of the metal member 20. On the metal member 20, a position where the conductive film 30 is formed is not limited to the above example. The conductive film 30 may be formed only on a side joined to the base 10 via the joining portion 50.

The barrier film 40 is formed between the conductive film 30 and the joining portion 50 described later. In the present embodiment, the barrier film 40 is made of platinum and is formed so as to coat the outer side of the conductive film 30. The barrier film 40 inhibits dispersion of gold atoms and tin atoms contained in the joining portion 50.

A gold film 45 is formed so as to coat the outer side of the barrier film 40. The gold film 45 is made of gold and assists joining between the metal member 20 and the joining portion 50 via the barrier film 40.

The joining portion 50 joins a side of the metal member 20 where the conductive film 30 is formed, to the base 10. The joining portion 50 is made of a nonmagnetic material. In the present embodiment, the joining portion 50 is solder made of gold and tin. The joining portion 50 joins the base 10 and the metal member 20. The nonmagnetic material forming the joining portion 50 may be the same as or different from the nonmagnetic material contained in the insulating member 11 or the metal member 20.

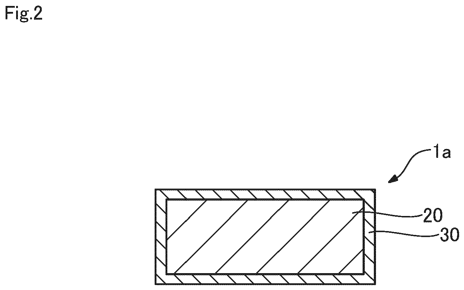

Fig. 2 is a first view illustrating a manufacturing method for the semiconductor substrate 1 of the present embodiment. Here, the manufacturing method for the semiconductor substrate 1 will be described. In the manufacturing method for the semiconductor substrate 1, first, the metal member 20 is prepared. Next, the conductive film 30 is formed on the prepared metal member 20. Specifically, plating treatment using copper is performed on the metal member 20, and annealing treatment is performed to heat the metal member 20 that has undergone the plating treatment. In the present embodiment, the plating treatment and the annealing treatment are repeatedly performed twice. The member obtained by forming the conductive film 30 on the metal member 20 as shown in Fig. 2 is referred to as a plated member 1a, for convenience sake.

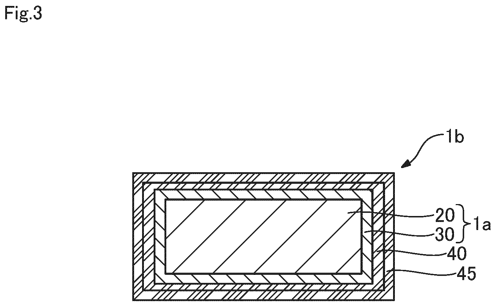

Fig. 3 is a second view illustrating the manufacturing method for the semiconductor substrate 1 of the present embodiment. After the conductive film 30 is formed on the metal member 20, the barrier film 40 and the gold film 45 are formed on the surface of the plated member 1a. In the present embodiment, the barrier film 40 is formed by sputtering using platinum, and the gold film 45 is formed by sputtering using gold. A method for forming the barrier film 40 or the gold film 45 is not limited to sputtering, and may be plating treatment or vapor deposition. The member obtained by forming the barrier film 40 and the gold film 45 on the surface of the plated member 1a is referred to as a sputtered member 1b, for convenience sake.

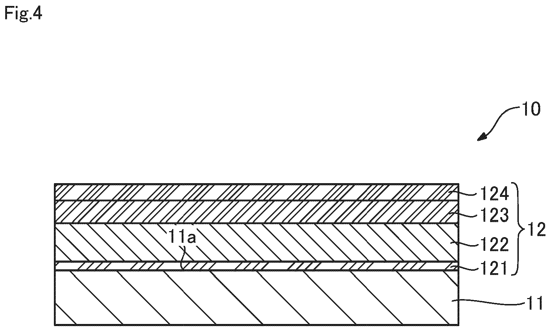

Fig. 4 is a third view illustrating the manufacturing method for the semiconductor substrate 1 of the present embodiment. In the manufacturing method for the semiconductor substrate 1, the nonmagnetic film 12 is formed on the prepared insulating member 11, separately from the manufacturing of the sputtered member 1b described in Fig. 2 and Fig. 3. Specifically, the titanium film 121, the copper film 122, the platinum film 123, and the gold film 124 are formed in this order on the surface 11a of the insulating member 11. In the present embodiment, the titanium film 121 is formed by sputtering using titanium, and the copper film 122 is formed by sputtering and plating using copper. The platinum film 123 is formed by vapor deposition using platinum, and the gold film 124 is formed by vapor deposition using gold. Thus, the base 10 is manufactured. A method for forming the titanium film 121, the copper film 122, the platinum film 123, or the gold film 124 is not limited to sputtering or vapor deposition, and for example, a part of these films may be formed through plating treatment.

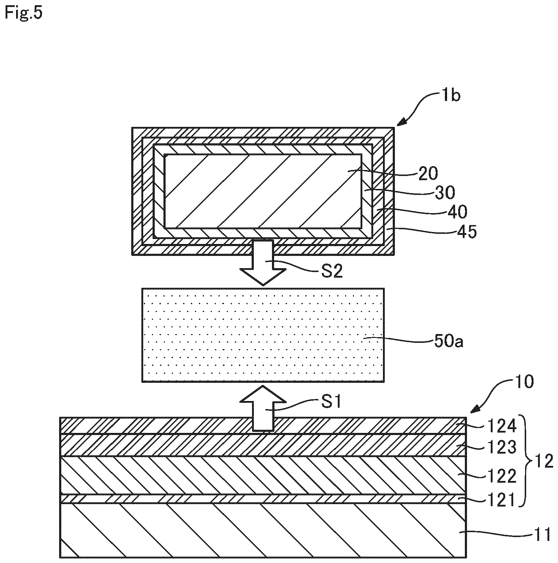

Fig. 5 is a fourth view illustrating the manufacturing method of the semiconductor substrate 1 of the present embodiment. In the manufacturing method for the semiconductor substrate 1, a gold-tin solder foil 50a is prepared separately from the sputtered member 1b and the base 10. The gold-tin solder foil 50a is interposed between the gold film 45 of the sputtered member 1b and the gold film 124 of the base 10 (blank arrows S1 and S2 in Fig. 5). In a state in which the gold-tin solder foil 50a is interposed between the sputtered member 1b and the base 10, these are heated in a reflow furnace with a nitrogen atmosphere or a hydrogen atmosphere. Thus, the sputtered member 1b and the base 10 are joined via the joining portion 50, whereby the semiconductor substrate 1 is manufactured. A method for joining the sputtered member 1b and the base 10 is not limited to the method using the gold-tin solder foil 50a, and a method of applying a gold-tin solder paste may be used.

In the semiconductor substrate 1 of the present embodiment described above, the conductive film 30 formed on the metal member 20 is made of copper which is the same material as the nonmagnetic material contained in the metal member 20. Thus, occurrence of a defect such as swell between the metal member 20 and the conductive film 30 is inhibited, whereby adhesion between the metal member 20 and the conductive film 30 is enhanced. Accordingly, it is possible to enhance adhesion between the base 10 and the metal member 20 joined via the conductive film 30 and the joining portion 50.

In the semiconductor substrate 1 of the present embodiment, the base 10 includes the insulating member 11 made of aluminum nitride which is a nonmagnetic material, and the nonmagnetic film 12 formed on the insulating member 11. Thus, the base 10 has a nonmagnetic property, and therefore, when the base 10 is joined to the metal member 20 having a nonmagnetic property, the semiconductor substrate 1 has a nonmagnetic property in its entirety. Accordingly, the semiconductor substrate 1 is less influenced by a magnetic field and therefore can be applied to fields in which a nonmagnetic property is needed.

The semiconductor substrate 1 of the present embodiment includes the barrier film 40 formed between the conductive film 30 and the joining portion 50. Thus, gold atoms and tin atoms contained in the joining portion 50 can be inhibited from being dispersed into the conductive film 30.

In the semiconductor substrate 1 of the present embodiment, the metal member 20 is made of an alloy of tungsten and copper, and the conductive film 30 is made of copper which is the same material as the nonmagnetic material forming the metal member 20. Thus, the conductive film 30 becomes less likely to be separated from the metal member 20, so that adhesion between the metal member 20 and the conductive film 30 is enhanced. Accordingly, it is possible to enhance adhesion between the base 10 and the metal member 20 joined via the conductive film 30 and the joining portion 50.

In the manufacturing method for the semiconductor substrate 1 of the present embodiment, when the conductive film 30 is to be formed on the metal member 20, plating treatment using copper and annealing treatment of heating the film formed through plating treatment are performed a plurality of times. Thus, the residue of a plating liquid remaining at the film formed through the plating treatment evaporates and grain growth of copper is promoted, whereby adhesion between the metal member 20 and the conductive film 30 can be further enhanced. Accordingly, it is possible to enhance adhesion between the base 10 and the metal member 20 joined via the conductive film 30 and the joining portion 50.

### <Modifications of embodiment>

The present invention is not limited to the above embodiment and can be implemented in various embodiments without deviating from the gist of the present invention. For example, the following modifications are also possible.

### [Modification 1]

In the above embodiment, it has been described that the base 10 includes the insulating member 11 made of a nonmagnetic material, and the nonmagnetic film 12 formed on the insulating member 11. However, the configuration of the base 10 is not limited thereto, and the base 10 may include only the insulating member 11. In the above embodiment, it has been described that the base 10 includes the insulating member 11 and the nonmagnetic film 12, and for example, the insulating member 11 is joined to the metal member 20 via the nonmagnetic film 12 and the joining portion 50, as shown in Fig. 1. However, the joining manner between the insulating member 11 and the metal member 20 is not limited thereto. The insulating member 11 may be joined to the metal member 20 via the joining portion 50, on a side of the insulating member 11 where the nonmagnetic film 12 is not formed. The nonmagnetic material forming the insulating member 11 is not limited to aluminum nitride, and may not necessarily have an insulation property. The nonmagnetic material forming the insulating member 11 may be the same as or different from the nonmagnetic material contained in the metal member 20 or the joining portion 50.

### [Modification 2]

In the above embodiment, it has been described that the semiconductor substrate 1 includes the barrier film 40, but the barrier film may be absent. Providing the barrier film 40 can inhibit gold atoms and tin atoms contained in the joining portion 50 from being dispersed into the conductive film 30.

### [Modification 3]

In the above embodiment, it has been described that the metal member 20 is a heat sink made of an alloy of tungsten and copper. The material forming the metal member and the function of the metal member are not limited thereto. It suffices that the metal member contains a nonmagnetic material and has a nonmagnetic property.

### [Modification 4]

In the above embodiment, it has been described that the conductive film 30 formed on the metal member 20 is formed by performing plating treatment and annealing treatment using copper on the metal member 20. However, a method for forming the conductive film 30 is not limited thereto. The conductive film 30 may be formed through sputtering or vapor deposition.

While the present aspect has been described above using the embodiment and modifications, the embodiment described above is merely for facilitating the understanding of the present aspect and is not intended to limit the present aspect. The present aspect may be subjected to change or modification without deviating from the gist thereof and the scope of the claims, and the present aspect includes equivalents thereof. Further, such technical features can be deleted as appropriate if not described as being essential in the present specification.

### <Application example 1>

A semiconductor substrate comprising:
a base;
a metal member containing a nonmagnetic material and having a nonmagnetic property;
a conductive film formed on the metal member and made of the same material as the nonmagnetic material contained in the metal member; and
a joining portion joining a side of the metal member where the conductive film is formed, to the base, the joining portion being made of a nonmagnetic material.

### <Application example 2>

The semiconductor substrate in accordance with application example 1, wherein
the base includes
an insulating member made of a nonmagnetic material, and
a nonmagnetic film formed on the insulating member.

### <Application example 3>

The semiconductor substrate in accordance with application example 1 or 2, further comprising a barrier film formed between the conductive film and the joining portion.

### <Application example 4>

The semiconductor substrate in accordance with any one of application examples 1 to 3, wherein
the metal member is made of an alloy of tungsten and copper, and
the conductive film is made of copper.

### DESCRIPTION OF REFERENCE NUMERALS

1: semiconductor substrate
10: base
11: insulating member
12: nonmagnetic film
20: metal member
30: conductive film
40: barrier film
50: joining portion

The present application is also directed to the following embodiments:
[Embodiment 1] A semiconductor substrate(1) comprising:
   a base(10);
   a metal member(20) containing a nonmagnetic material and having a nonmagnetic property;
   a conductive film(30) formed on the metal member and made of the same material as the nonmagnetic material contained in the metal member; and
   a joining portion(50) joining a side of the metal member where the conductive film is formed, to the base, the joining portion being made of a nonmagnetic material.
[Embodiment 2] The semiconductor substrate in accordance with embodiment 1, wherein
   the base includes
   an insulating member(11) made of a nonmagnetic material, and
   a nonmagnetic film(12) formed on the insulating member.
[Embodiment 3] The semiconductor substrate in accordance with embodiment 1 or 2, further comprising a barrier film(40) formed between the conductive film and the joining portion.
[Embodiment 4] The semiconductor substrate in accordance with embodiment 1 or 2, wherein
   the metal member is made of an alloy of tungsten and copper, and
   the conductive film is made of copper.

## Claims

1. A semiconductor substrate(1) comprising:
a base(10);
a metal member(20) containing a nonmagnetic material and having a nonmagnetic property;
a conductive film(30) formed on the metal member and containing the same material as the nonmagnetic material contained in the metal member; and
a joining portion(50) joining a side of the metal member where the conductive film is formed, to the base, the joining portion being made of a nonmagnetic material.

2. The semiconductor substrate in accordance with claim 1, wherein
the base includes
an insulating member(11) made of a nonmagnetic material, and
a nonmagnetic film(12) formed on the insulating member.

3. The semiconductor substrate in accordance with claim 1 or 2, further comprising a barrier film(40) formed between the conductive film and the joining portion.

4. The semiconductor substrate in accordance with claim 1 or 2, wherein
the metal member is made of an alloy of tungsten and copper, and
the conductive film is made of copper.

5. The semiconductor substrate in accordance with any one of claims 1 to 4, comprising:
a conductive film(30) formed on the metal member and made of the same material as the nonmagnetic material contained in the metal member.
